# EUROPEAN PATENT SPECIFICATION

(11) **EP 3 284 101 B1**
(45) Date of publication and mention of the grant of the patent: **07.09.2022**
(21) Application number: 16780580.3
(22) Date of filing: 13.04.2016
(51) Int. Cl.: C09G 1/02, H01L 21/304, B24B 37/04, C09K 3/14, H01L 21/768, H01L 21/306, H01L 21/321

(54) **DIAMOND-BASED SLURRIES WITH IMPROVED SAPPHIRE REMOVAL RATE AND SURFACE ROUGHNESS**
DIAMANTBASIERTE AUFSCHLÄMMUNGEN MIT VERBESSERTER SAPHIR-ENTFERNUNGSRATE UND OBERFLÄCHENRAUHEIT
SUSPENSIONS À BASE DE DIAMANT PRÉSENTANT UN TAUX D'ÉLIMINATION DE SAPHIR ET UNE RUGOSITÉ DE SURFACE AMÉLIORÉS

(30) Priority: 13.04.2015 US 201562146713 P
(43) Date of publication of application: 21.02.2018
(73) Proprietor: CMC Materials, Inc., Aurora, IL 60504 (US)
(72) Inventor: PANDEY, Prativa, Aurora, Illinois 60504 (US); REISS, Brian, Aurora, Illinois 60504 (US); WHITE, Michael, Aurora, Illinois 60504 (US)
(74) Representative: Barker Brettell LLP
(86) International application number: PCT/US2016/027189
(87) International publication number: WO 2016/168231

(56) References cited:
- JP-A- 2011 040 427
- JP-A- 2014 216 464
- KR-A- 20150 009 914
- KR-A- 20150 115 633
- US-A1- 2010 258 528
- US-A1- 2014 124 793
- US-A1- 2015 004 788

## Description

### BACKGROUND OF THE INVENTION

Sapphire is the single-crystal form of aluminum oxide (Al₂O₃) possessing excellent optical, mechanical, and chemical properties. For example, sapphire retains its high strength at high temperatures, has good thermal properties, excellent transparency, excellent chemical stability, possesses chip resistance, durability, scratch resistance, radiation resistance, and flexural strength at elevated temperatures.

Sapphire is increasingly becoming the material of choice for engineers faced with design challenges in the semiconductor manufacturing industry. For example, the properties provided by sapphire make it suitable for use in plasma containment tubes, process gas injectors, thermocouple protection assemblies, viewports and sight windows, end effectors, gas diffusion plates, substrates, and wafers.

Sapphire wafers are commonly cut along a number of crystallographic axes, such as the C-plane (0001 orientation, also called the 0-degree plane or the basal plane), the A-plane (11-20 orientation, also referred to as 90 degree sapphire) and the R-plane (1-102 orientation, 57.6 degrees from the C-plane). R-plane sapphire, which is particularly preferred for silicon-on-sapphire materials used in semiconductor, microwave and pressure transducer application, is about 4 times more resistant to polishing than C-plane sapphire, which is typically used in optical systems, infrared detectors, and growth of gallium nitride for light-emitting diode applications.

While sapphire provides numerous advantages, due to sapphire's hardness and resistance to chemical attack, polishing and planarizing sapphire presents many difficulties. Hard abrasives having high removal rates are often required to provide acceptable polishing rates. However, these abrasives can scratch and damage the sapphire surface. While softer, slower acting abrasives can be used to reduce this potential for scratching and damage, the downside with such abrasives is the often unacceptable times required to achieve the desired level of surface polishing and planarization.

Given these and other deficiencies observed in the art, it would be highly desirable to develop improved abrasive slurry compositions that provide fast removal rate while still minimizing defects and scratching.

### DETAILED DESCRIPTION OF THE INVENTION

The invention provides a polishing composition and a method of polishing a substrate. The polishing composition provides diamond abrasive particles, in the size range of 2 µm to 4 µm. The composition also comprises a medium in which the particles are suspended. The polishing composition also comprises acid or base additives to adjust the pH, and wherein the pH of the polishing composition is from 3 to 7.

Embodiments of the invention provide a diamond based polishing composition that exhibits high removal rates and low surface roughness for sapphire substrates. In accordance with some embodiments, the diamond based polishing composition is used to polish a sapphire substrate in a chemical-mechanical polishing process.

The substrate to be polished using the polishing composition and method of the invention can be any suitable sapphire substrate. For example, the sapphire substrate may be a C-plane sapphire substrate, or an A-plane sapphire substrate. In some embodiments, A-plane sapphire substrates are preferred.

The polishing composition includes diamond abrasive particles. Any suitable diamond abrasive particle may be used. The diamond abrasive particles are preferably particles with a relatively large average particle size. The diamond abrasive may be irregularly shaped, or with a smooth surface. Preferably, the diamond abrasive is preferably irregularly shaped.

The diamond particles can have any suitable average particle size (i.e., average particle diameter). For clarity, it will be understood that, for non-spherical particles, the size of the particle is the diameter of the smallest sphere that encompasses the particle. The diamond has an average particle size of from 2 µm to 4 µm.

The diamond particles can be present in any suitable amount. For example, the diamond particles can be present in an amount of from about 0.5 wt % to about 2 wt.%. In some embodiments, the diamond particle is present, e.g., in an amount from about 0.25 wt.% to about 5 wt.%, such as from about 0.5 wt.% to about 4 wt.%, such as from about 0.5 wt.% to about 3 wt.%, or from about 0.25 wt.% to about 2 wt.%. Preferably, the diamond particles are present in an amount of from about 0.5 wt % to about 2 wt.%.

The polishing composition optionally may contain a second diamond abrasive of a smaller average particle size. For example, the polishing compositions of the present invention may comprise second diamond particle with an average particle size of less than about 1 nm. For example, in some embodiments, the second diamond particle has an average particle size of from about 0.01 nm to about 1 nm. In some embodiments, the diamond particle has an average particle size of, e.g., from about 0.1 nm to about 0.5 nm, from about 0.1 nm to about 1 nm, or from about 0.01 nm to about 0.5 nm.

The polishing composition comprises a pH adjusting component. The pH adjusting component may be an acid or a base. Any suitable pH adjusting component may be used. Preferably, an acid may be nitric acid, sulfuric acid, hydrochloric acid or phosphoric acid. When the pH adjusting component is a base, preferably the base is sodium, potassium, cesium or ammonium hydroxide.

In some embodiments, the polishing composition liquid medium comprises water or a water soluble organic solvent, such as a glycol. For example, the polishing composition may comprise distilled water, ethylene glycol, propylene glycol or mixtures thereof.

In some embodiments, the polishing composition may include a polishing additive. The polishing additive is a compound that complexes with aluminum ion. Without limitation, the polishing additive may be a quaternary ammonium polymer or copolymer, such as a copolymer of diallyl dimethyl ammonium chloride and acrylic acid (e.g. Merquat 280). Further, the polishing additive may be maltol.

The polishing composition optionally includes a surfactant, a polymer, a complexing agent, rheology modifiers, thickening agents and/or a chelating agent. In some embodiments, the polymer and surfactant are water or alcohol soluble, or water or alcohol dispersible. In some embodiments, the complexing agent and chelating agent are soluble or dispersible in any suitable liquid medium.

The polishing composition of the invention has a pH from 3 to 7.

If desired, to achieve such a pH level, a pH adjuster can be utilized. Any suitable pH adjuster can be included in the polishing composition. By way of example, the pH adjuster can be in the form of one or more of nitric acid, sulfuric acid, and phosphoric acid. The pH adjuster is included in an amount effective to achieve the desired pH level, such as in an amount of from about 0.0001 wt.% to about 20 wt.%, e.g., from about 0.001 wt.% to about 10 wt.%, from about 0.01 wt.% to about 5 wt.%, or from about 0.02 wt.% to about 3 wt.%.

Biocides as known in the art can be used in some embodiments. The biocide can be any suitable biocide and can be present in the polishing composition in any suitable amount. By way of example, and not limitation, a suitable biocide is an isothiazolinone biocide, isothiazolinone, or the like. The amount of biocide used in the polishing composition typically can be from about 1 to about 60 ppm, e.g., about 1 to about 50 ppm, such as about 10 to about 20 ppm.

The polishing composition can be prepared by any suitable technique, many of which are known to those skilled in the art. The polishing composition can be prepared in a batch or continuous process. Generally, the polishing composition can be prepared by combining the components thereof in any order.

**It** will be understood that, generally, the actual quantity of one or more ingredient in compositions in accordance with embodiments of the invention (e.g., diamond abrasives, polishing additives; and water) may vary depending on the desired degree of dilution or concentration. In this respect, some embodiments can be packaged in the form of a concentrate (e.g., a 50 times concentrate, a 100 times concentrate, a 200 times concentrate, etc.) where water can be later added to dilute the solution, such as at a point of use (e.g., by an end user), or the solution can be packaged in a diluted form with water already included. For example, in some embodiments, the concentrated forms of each ingredient and/or the solution as a whole can facilitate ease of shipping, distribution, and sale. However in other embodiments, each ingredient and/or the solution as a whole can be in a diluted form, e.g., to simplify end use. Thus, the weight ranges for ingredients as set forth herein can refer to either the diluted or concentrated ranges.

Accordingly, each ingredient can be present in a diluted form that is suitable for end use or in a form that is concentrated and then diluted (e.g., 2 times, 5 times, 10 times, 25 times, 40 times, 50 times, 60 times, 70 times, 100 times, 125 times, 150 times, 175 times, 200 times, etc. to the diluted form). When the concentrate is diluted with an equal weight of water (e.g., 1 equal weight of water, 4 equal weight of water, 9 equal weight of water, 24 equal weight of water, 39 equal weight of water, 49 equal weight of water, 59 equal weight water, 69 equal weight of water, 99 equal weight of water, 124 equal weight of water, respectively), each ingredient will be present in embodiments of the invention in an amount within the diluted ranges set forth below for each component. Furthermore, as will be understood by those of ordinary skill in the art, the concentrate can contain an appropriate fraction of the water present in the final solution. For example, in some applications, e.g., polishing compositions, the concentrate can contain an appropriate fraction of the water present in the final polishing composition in order to ensure that the polishing composition components are at least partially or fully dissolved in the concentrate.

As another illustrative embodiment, the polishing composition comprises, consists of, or consists essentially of a diamond abrasive, a pH adjusting additive and water.

In another illustrative embodiment, the composition comprises, consists of, or consists essentially of a diamond abrasive, a pH additive and an organic solvent, such as a glycol.

In another illustrative embodiment, the composition comprises, consists of, or consists essentially of diamond abrasives, a pH additive, a polishing additive and water.

In another illustrative embodiment, the composition comprises, consists of, or consists essentially of diamond abrasives, a pH additive, a polishing additive and an organic solvent, such as a glycol.

It will be further understood that embodiments "consisting essentially of the recited ingredients or method steps means that the composition precludes the inclusion of any additional ingredient or method step that materially affects the inventive polishing composition or method (e.g., ingredients or method steps that alter the desired effects of the invention, particularly with regard to removal rate as discussed herein or increasing negative effects on polishing performance (e.g., particularly with respect to surface roughness or defectivity)). Compounds or method steps that do not affect the removal rate or polishing performance with respect to surface roughness or defectivity can be included in such embodiments "consisting essentially of" the recited ingredients or method steps.

The invention also provides a method of polishing a sapphire substrate. The polishing method of the invention is particularly suited for use in conjunction with a chemical-mechanical polishing (CMP) apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving relative to the surface of the polishing pad. The polishing of the substrate takes place by the substrate being placed in contact with the polishing pad and the polishing composition of the invention and then the polishing pad moving relative to the substrate, so as to abrade at least a portion of the substrate to polish the substrate.

A sapphire substrate can be planarized or polished with the chemical-mechanical polishing composition with any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

The method of polishing a substrate comprises, consists of, or consists essentially of (i) providing a substrate, (ii) providing a polishing pad, and (iii) providing a polishing composition as described herein in various embodiments. In the method, the polishing composition is dispensed to the surface of the substrate and the polishing pad contacts the surface of the substrate. The method also includes abrading at least a portion of the surface of the substrate to remove at least some portion of the substrate and to polish the surface of the substrate.

The following Examples further illustrate the invention but, of course, should not be construed as in any way limiting its scope.

### EXAMPLE 1

This Example demonstrates the effects of pH and diamond abrasive size in the slurry composition for polishing sapphire substrates.

All of the polishing data shown in Tables 1 and 2 were obtained on a Hyprez 15" polishing tool using MH (Eminess Technologies, Scottsdale, AZ), IC1000^{™} (Dow Chemical Corporation, Midland, MI) or D100^{™} (Cabot Microelectronics Corporation, Aurora, IL) polishing pads at slurry flow rate of 30-60 mL/min and at 3-4 psi down force. Diamond abrasives were added at 0.5-2 wt.% solids in the formulations, suspended in either distilled water (DIW) or ethylene glycol. The diamond abrasives were either GMM (Item number 15231007, Sandvik Hyperion, New Jersey, USA) having a particle size of 0.1-0.5 nm, Hyperion (Sandvik Hyperion, New Jersey, USA) having a particle sizes of either 1-3 µm, 2-3 µm or 2-4 µm. The slurry compositions were adjusted to target pH values using either nitric acid or potassium hydroxide. The Sapphire substrates were 2 inch, A-plane wafers. The removal rate was measured by mass difference, by subtracting the final mass from the initial mass.

The data is shown in Tables 1 and 2 below. The data indicate that the larger diamond particle size gave increased removal rates for sapphire, when compared to the smaller GMM diamond particles. Additionally, the polishing rates increased as the pH value decreased from 11.

**Table 1: Polishing data showing the effect of pH on sapphire removal rates using GMM 0-0.5 nm diamond-based slurries**

| | Composition | pH | Medium for dispersion | Removal Rate (µm/h) |
|---|---|---|---|---|
| Slurry #1 | GMM 0-0.5 Diamond+Base | 11 | DIW | 1.8 |
| Slurry #2 | GMM 0-0.5 Diamond+Base | 9 | DIW | 1.8 |
| Slurry #3 | GMM 0-0.5 Diamond+Base | 6 | DIW | 4.1 |
| Slurry #4 | GMM 0-0.5 Diamond+Base | 5 | DIW | 4.3 |
| Slurry #5 | GMM 0-0.5 Diamond | 4.6 | DIW | 4.3-5.9 |
| Slurry #6 | GMM 0-0.5 Diamond+acid | 4 | DIW | 3.6 |
| Slurry #7 | GMM 0-0.5 Diamond+acid | 3.5 | DIW | 3.5 |

**Table 2: Polishing data showing the effect of pH on sapphire removal rates using Hyperion 2-4µm diamond-based slurries**

| | Composition | pH | Liquid Medium | Removal Rate (µm/h) |
|---|---|---|---|---|
| Slurry #1 | Hyperion 2-4µm Diamond+Base | 11 | Ethylene glycol | 27.5 |
| Slurry #2 | Hyperion 2-4µm Diamond+Base | 9 | Ethylene glycol | 27.2 |
| Slurry #3 | Hyperion 2-4µm Diamond+ Acid | 7.8 | Ethylene glycol | 31.1 |
| Slurry #4 | Hyperion 2-4µm Diamond+ Acid | 7 | Ethylene glycol | 40.6 |
| Slurry #5 | Hyperion 2-4µm Diamond+ Acid | 6 | Ethylene glycol | 52.9 |
| Slurry #6 | Hyperion 2-4µm Diamond+ Acid | 5 | Ethylene glycol | 50.9 |
| Slurry #7 | Hyperion 2-4µm Diamond+ Acid | 4.5 | Ethylene glycol | 56.6 |

### EXAMPLE 2

This Example demonstrates the effect of diamond size and slurry chemistry on removal rates and surface roughness in sapphire polishing compositions.

The polishing conditions were identical to those described in Example 1. The sapphire substrate had a pre-polishing roughness of about 1500nm - 1700 nm. Table 3 describes the compositions of the tested slurries. All of the slurries in Table 3 were prepared using either 1 wt.% or 2 wt.% (2X) diamond particles. The diamond particles were either the smaller GMM or larger Hyperion particles. The liquid medium was either, distilled water, ethylene glycol or propylene glycol. In slurries 6 and 7, the described amount of a copolymer of diallyl dimethyl ammonium chloride and acrylic acid (Merquat^{™} 280, Lubrizol) polishing additive was added at 1 wt.% or 0.02 wt.%, respectively. In slurry 8, the polishing additive was 1 wt.% maltol. Slurry 12 contained a polyurethane-based rheology modifier (Rheovis PU1191, BASF). The pH for the slurries was adjusted to 4.5 +/- 0.1 using either an acid or base, as described in Example 1. The removal rate was determined as described in Example 1. The surface roughness was determined using a Zygo New View^{™} (Zygo Corporation, Middlefield, CT) and analyzed using Metropro 8.1.5 software (Zygo Corporation, Middlefield, CT).

The results from Table 3 show that the inventive slurries show both a high polishing rate and a low surface roughness.

**Table 3: Polishing data showing removal rates and surface roughness improvement of different diamond based-slurries.**

| | Composition | Liquid Medium | Removal Rate (µm/h) | Surface Roughness. Ra (A) |
|---|---|---|---|---|
| Slurry #1 | GMM 0-0.5 Diamond | DIW or Ethylene glycol | 5.9 | 8-20 |
| Slurry #2 | Hyperion 2-4µm Diamond (2X Solids)+Acid | Ethylene glycol | 34.5 | 18-20 |
| Slurry #3 | Hyperion 2-4µm Diamond | Ethylene glycol | 31.1 | 22-27 |
| Slurry #4 | GMM 0-0.5 Diamond+ Hyperion 2-4µm Diamond+Acid | Ethylene glycol | 25.4 | 6-12 |
| Slurry #5 | Hyperion 2-4µm Diamond+ Acid | Ethylene glycol | 52.9 | 9-20 |
| Slurry #6 | Hyperion 2-4µm Diamond+1wt% Merquat 280+Acid | Ethylene glycol | 18.0 | 6-10 |
| Slurry #7 | Hyperion 2-4µm Diamond+0.02wt% Merquat 280+Acid | Ethylene glycol | 51.8 | -- |
| Slurry #8 | Hyperion 2-4µm Diamond+1wt% maltol+Acid | Ethylene glycol | 30 | 9-12 |
| Slurry #9 | Hyperion 2-4µm Diamond+ Acid | Propylene glycol (50-100% in DIW) | 12-17 | -- |
| Slurry #10 | Hyperion 2-4µm Diamond+malic acid+Acid | Ethylene glycol | 26.2 | 10.6 |
| Slurry #11 | Hyperion 2-4µm Diamond+Malic acid+ Rheovis PU1191+Acid | Ethylene glycol | 17.4 | 8.2 |
| Slurry #12 | Hyperion 2-4 µm Diamond+0.15 wt.% Rheovis PU1191 + Acid | Ethylene glycol (50-100% in DIW) | 25 | <10 |
| Slurry #13 | Hyperion 2-3 µm Diamond + Acid | Ethylene glycol | 24.4 | 7.9 |
| Slurry #14 | Hyperion 1-3 µm Diamond + Acid | Ethylene glycol | 17.1 | 6.4 |
| Slurry #15 | Hyperion 1-3 µm + Hyperion 2-4 µm Diamond + Acid | Ethylene glycol | 17.4 | 7.6 |
| Slurry #16 | Hyperion 2-3 µm + Hyperion 2-4 µm Diamond + Acid | Ethylene glycol | 24.1 | 8.0 |
| Slurry #17 | Hyperion 1-3 µm + Hyperion 2-3 µm Diamond + Acid | Ethylene glycol | 28.8 | 10.5 |

## Claims

1. A chemical-mechanical polishing composition comprising:
(a) diamond abrasive;
(b) pH adjusting compound;
(c) optionally, a polishing additive; and
(d) a liquid medium comprising water, a water soluble organic compound, or a combination thereof,
wherein the diamond abrasive has an average size of 2 µm to 4 µm and wherein the pH of the polishing composition is from 3 to 7.

2. The composition of claim 1 wherein the pH adjusting compound is an acid.

3. The composition of claim 1 wherein the pH adjusting compound is a base.

4. The composition of claim 1 wherein the liquid medium is a water soluble organic compound.

5. The composition of claim 1 wherein the liquid medium is a glycol.

6. The composition of claim 1 wherein the liquid medium is distilled water.

7. The composition of claim 1 wherein the polishing additive is present.

8. The composition of claim 7 wherein the polishing additive is selected from the group consisting of a surfactant, a polymer, a chelating agent or a complexing agent, and combinations thereof.

9. The composition of claim 7 wherein the polishing additive is a copolymer of diallyl dimethyl ammonium chloride and acrylic acid.

10. The composition of claim 7 wherein the polishing additive is maltol.

11. The composition of claim 1, further comprising a second diamond abrasive having an average particle size of less than 1 nm.

12. A chemical-mechanical polishing method for polishing a sapphire substrate which method comprises:
(i) contacting a sapphire substrate with a polishing pad and the polishing composition of claim 1:
(ii) moving the polishing pad and the polishing composition relative to the substrate to abrade at least a portion of the substrate to polish the substrate.

## Patentansprüche

1. Zusammensetzung zum chemisch-mechanischen Polieren, umfassend:
(a) ein Diamant-Schleifmittel;
(b) eine Verbindung zur Einstellung des pH-Werts;
(c) gegebenenfalls ein Polieradditiv und
(d) ein flüssiges Medium, das Wasser, eine wasserlösliche organische Verbindung oder eine Kombination davon umfasst,
wobei das Diamant-Schleifmittel eine durchschnittliche Größe von 2 µm bis 4 µm aufweist und wobei der pH-Wert der Polierzusammensetzung 3 bis 7 beträgt.

2. Zusammensetzung nach Anspruch 1, wobei es sich bei der Verbindung zur Einstellung des pH-Werts um eine Säure handelt.

3. Zusammensetzung nach Anspruch 1, wobei es sich bei der Verbindung zur Einstellung des pH-Werts um eine Base handelt.

4. Zusammensetzung nach Anspruch 1, wobei es sich bei dem flüssigen Medium um eine wasserlösliche organische Verbindung handelt.

5. Zusammensetzung nach Anspruch 1, wobei es sich bei dem flüssigen Medium um ein Glykol handelt.

6. Zusammensetzung nach Anspruch 1, wobei es sich bei dem flüssigen Medium um destilliertes Wasser handelt.

7. Zusammensetzung nach Anspruch 1, wobei das Polieradditiv vorliegt.

8. Zusammensetzung nach Anspruch 7, wobei das Polieradditiv aus der Gruppe bestehend aus einem Tensid, einem Polymer, einem Chelatbildner oder einem Komplexbildner und Kombinationen davon ausgewählt ist.

9. Zusammensetzung nach Anspruch 7, wobei es sich bei dem Polieradditiv um ein Copolymer von Diallyldimethylammoniumchlorid und Acrylsäure handelt.

10. Zusammensetzung nach Anspruch 7, wobei es sich bei dem Polieradditiv um Maltol handelt.

11. Zusammensetzung nach Anspruch 1, ferner umfassend ein zweites Diamant-Schleifmittel mit einer durchschnittlichen Teilchengröße von weniger als 1 nm.

12. Verfahren zum chemisch-mechanischen Polieren zum Polieren eines Saphirsubstrats, wobei das Verfahren Folgendes umfasst:
(i) Inkontaktbringen eines Saphirsubstrats mit einem Polierkissen und der Polierzusammensetzung nach Anspruch 1;
(ii) Bewegen des Polierkissens und der Polierzusammensetzung relativ zum Substrat zum Abtragen mindestens eines Teils des Substrats zum Polieren der Oberfläche.

## Revendications

1. Composition de polissage chimique-mécanique comprenant :
(a) un abrasif diamant ;
(b) un composé d'ajustement du pH ;
(c) optionnellement, un additif de polissage ; et
(d) un milieu liquide comprenant de l'eau, un composé organique hydrosoluble, ou une combinaison de ceux-ci,
dans laquelle l'abrasif diamant a une taille moyenne de 2 µm à 4 µm et dans laquelle le pH de la composition de polissage est de 3 à 7.

2. Composition selon la revendication 1, dans laquelle le composé d'ajustement du pH est un acide.

3. Composition selon la revendication 1, dans laquelle le composé d'ajustement du pH est une base.

4. Composition selon la revendication 1, dans laquelle le milieu liquide est un composé organique hydrosoluble.

5. Composition selon la revendication 1, dans laquelle le milieu liquide est un glycol.

6. Composition selon la revendication 1, dans laquelle le milieu liquide est de l'eau distillée.

7. Composition selon la revendication 1, dans laquelle l'additif de polissage est présent.

8. Composition selon la revendication 7, dans laquelle l'additif de polissage est sélectionné dans le groupe constitué d'un tensioactif, d'un polymère, d'un agent chélatant ou d'un agent complexant, et de combinaisons de ceux-ci.

9. Composition selon la revendication 7, dans laquelle l'additif de polissage est un copolymère de chlorure de diallyldiméthylammonium et d'acide acrylique.

10. Composition selon la revendication 7, dans laquelle l'additif de polissage est le maltol.

11. Composition selon la revendication 1, comprenant en outre un deuxième abrasif diamant ayant une taille de particule moyenne inférieure à 1 nm.

12. Procédé de polissage chimique-mécanique pour le polissage d'un substrat de saphir, ledit procédé comprenant :
(i) la mise en contact d'un substrat de saphir avec une plaquette de polissage et la composition de polissage selon la revendication 1 ;
(ii) le déplacement de la plaquette de polissage et de la composition de polissage par rapport au substrat pour abraser au moins une partie du substrat afin de polir le substrat.
